Europäisches Patentamt

European Patent Office

Office européen des brevets

(19)

(11) Veröffentlichungsnummer: **0 169 468 B1**

## EUROPÄISCHE PATENTSCHRIFT

(45) Veröffentlichungstag der Patentschrift: 05.06.91

(51) Int. Cl.5: **H03K 17/945**

(21) Anmeldenummer: **85108789.0**

(22) Anmeldetag: **13.07.85**

(54) **Elektronisches, vorzugsweise berührungslos arbeitendes Schaltgerät.**

(30) Priorität: **26.07.84 DE 3427498**

(43) Veröffentlichungstag der Anmeldung:
**29.01.86 Patentblatt 86/05**

(45) Bekanntmachung des Hinweises auf die
Patenterteilung:
**05.06.91 Patentblatt 91/23**

(84) Benannte Vertragsstaaten:
**AT BE CH DE FR GB IT LI LU NL SE**

(56) Entgegenhaltungen:
**EP-A- 0 059 878**

**SIEMENS COMPONENTS, Band 18, Nr. 6, Dezember 1983, Seiten 250-252, Berlin, DE; A. HAUENSTEIN: "Two-wire inductive proximity switch for AC voltages using TCA 305 and SIPMOS transistor"**

**Tietze-Schenk "Halbleiter-Schaltungstechnik", Springer Verlag 1974.**

(73) Patentinhaber: **i f m electronic gmbh
Teichstrasse 4
W-4300 Essen 1(DE)**

(72) Erfinder: **Spähn, Hans-Peter, Ing. grad.
Birkensteige 24
W-7992 Tettnang(DE)**

(74) Vertreter: **Gesthuysen, Hans Dieter, Dipl.-Ing.
et al
Patentanwälte Gesthuysen + von Rohr
Huyssenallee 15 Postfach 10 13 33
W-4300 Essen 1(DE)**

## Beschreibung

Die Erfindung betrifft ein elektronisches, vorzugsweise berührungslos arbeitendes Schaltgerät, das über einen Außenleiter mit einem Pol einer - Gleichspannung oder Wechselspannung führenden - Betriebsspannungsquelle und nur über einen weiteren Außenleiter mit einem Anschluß eines Verbrauchers verbindbar ist, wobei der andere Anschluß des Verbrauchers mit dem anderen Pol der Betriebsspannungsquelle verbindbar ist, mit einem von außen beeinflußbaren Anwesenheitsindikator, z. B. einem Oszillator, mit einem von dem Anwesenheitsindikator - ggf. über einen Schaltverstärker - steuerbaren elektronischen Ausgangsschalter aus einem Ausgangstransistor und einem MOS-FET-Leistungstransistor und mit einer Zenerdiode, wobei der MOS-FET-Leistungstransistor, die Zenerdiode und der Ausgangstransistor in Reihe im Lastkreis liegen und wobei die Speisespannung bzw. der Speisestrom für den Anwesenheitsindikator und ggf. den Schaltverstärker am Verbindungspunkt von MOS-FET-Leistungstransistor und Zenerdiode bereitgestellt wird.

Elektronische Schaltgeräte der zuvor beschriebenen Art sind kontaktlos ausgeführt und werden in zunehmendem Maße anstelle von elektrischen, mechanisch betätigten Schaltgeräten, die kontaktbehaftet ausgeführt sind, in elektrische Meß-, Steuer- und Regelkreisen verwendet. Das gilt insbesondere für sogenannte Annäherungsschalter, d. h. für elektronische Schaltgeräte, die berührungslos arbeiten. Mit solchen Annäherungsschaltern wird indiziert, ob sich ein Beeinflussungselement, für das der entsprechende Annäherungsschalter sensitiv ist, dem Annäherungsschalter hinreichend weiter genähert hat. Hat sich nämlich ein Beeinflussungselement, für das der entsprechende Annäherungsschalter sensitiv ist, dem Anwesenheitsindikator hinreichend weit genähert, so steuert der Anwesenheitsindikator den Ausgangstransistor um, d. h. bei einem als Schließer ausgeführten Schaltgerät wird der bisher nicht-leitende Ausgangstransistor nunmehr leitend, während bei einem als Öffner ausgeführten Schaltgerät der bisher leitende Ausgangstransistor nunmehr sperrt. (Mit Schaltgeräten der in Rede stehenden Art kann auch indiziert werden, ob eine physikalische Größe eines Beeinflussungsmediums, für die das Schaltgerät sensitiv ist, einen entsprechenden Wert erreicht hat.)

Als Anwesenheitsindikator kann z. B. ein induktiv oder kapazitiv beeinflußbarer Oszillator vorgesehen sein; es handelt sich dann um induktive oder kapazitive Annäherungsschalter (vgl. z. B. die deutschen Offenlegungsschriften bzw. Auslegeschriften bzw. Patentschriften 19 51 137, 19 66 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 773, 26 28 427, 27 11 877 und 27 44 785). Als Anwesenheitsindikator kann z. B. auch ein Fotowiderstand, eine Fotodiode oder ein Fototransistor vorgesehen sein; es handelt sich dann um optoelektronische Annäherungsschalter (vgl. z. B. die deutsche Offenlegungsschrift 28 24 582).

Bei induktiven Annäherungsschaltern gilt für den Oszillator, solange ein Metallteil einen vorgegebenen Abstand noch nicht erreicht hat, daß der Oszillator schwingt, und zwar mit einer oberhalb eines Schwellwertes liegenden Amplitude der Oszillatorspannung. Erreicht das entsprechende Metallteil den vorgegebenen Abstand, so führt die zunehmende Bedämpfung des Oszillators dazu, daß der Oszillator nicht mehr schwingt oder nur noch mit einer unterhalb eines Schwellwertes liegenden Amplitude der Oszillatorspannung schwingt. Bei kapazitiven Annäherungsschaltern gilt für den Oszillator, solange ein Ansprechkörper die Kapazität zwischen einer Ansprechelektrode und einer Gegenelektrode noch nicht hinreichend vergrößert hat, also einen vorgegebenen Abstand noch nicht erreicht hat, daß der Oszillator nicht schwingt oder nur mit einer unterhalb eines Schwellwertes liegenden Amplitude der Oszillatorspannung schwingt. Erreicht der Ansprechkörper den vorgegebenen Abstand, so führt die nunmehr größere Kapazität zwischen der Ansprechelektrode und der Gegenelektrode dazu, daß der Oszillator schwingt, und zwar mit einer oberhalb eines Schwellwertes liegenden Amplitude der Oszillatorspannung. Bei beiden Ausführungsformen wird abhängig von der Amplitude der Oszillatorspannung der Ausgangstransistor gesteuert.

Optoelektronische Annäherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurückreflektiert. In beiden Fällen spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurückreflektiert wird.

Elektronische, berührungslos arbeitende Schaltgeräte sind anfangs mit einer Reihe von Problemen behaftet gewesen, - gemessen an elektrischen, mechanisch betätigten Schaltgeräten -, nämlich u. a. mit den Problemen "Darstellung einer Speisespannung für den Anwesenheitsindikator und ggf. den Schaltverstärker", "Ausbildung des Anwesenheitsindikators", "Einschaltimpulsverhinderung" und "Kurzschlußfestigkeit". Mit diesen Problemen und deren Lösungen (und mit anderen bei elektronischen, berührungslos arbeitenden Schaltgeräten relevanten Problemen und deren Lösungen) befassen sich z. B. die deutschen Offenlegungsschriften bzw. Auslegeschriften bzw. Patentschriften 19 51 137, 19 66 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 773, 26 28 427, 27 11 877, 27 44 785, 29 43 911, 30 04 829, 30 38 102, 30 38 141 und 30 38 692.

Bei elektronischen Schaltgeräten, die über einen Außenleiter mit einem Pol einer Betriebsspannungsquelle und nur über einen weiteren Außenleiter mit einem Anschluß eines Verbrauchers verbindbar sind, ist die Darstellung einer Speisespannung bzw. eines Speisestroms für den Anwesenheitsindikator und ggf. den Schaltverstärker nicht problemlos, weil ja sowohl im leitenden Zustand als auch im gesperrten Zustand des Schaltgerätes die Speisespannung bzw. der Speisestrom dargestellt werden muß.

Es ist belanglos, ob man von Darstellung einer Speisespannung oder von Darstellung eines Speisestroms spricht. Darstellung steht hier für Ableitung aus dem am Schaltgerät auftretenden Spannungsabfall bzw. aus den über das Schaltgerät geführten Betriebsstrom (leitender Zustand) bzw. aus der am Schaltgerät anstehenden Betriebsspannung bzw. aus dem über das Schaltgerät fließenden Reststrom (gesperrter Zustand). Es ist deshalb belanglos, ob man von Darstellung einer Speisespannung oder von Darstellung eines Speisestroms spricht, weil der Anwesenheitsindikator und ggf. der Schaltverstärker selbstverständlich eine Speisespannung und einen Speisestrom benötigen.

Von ihrer Funktion als Schaltgeräte her soll bei den in Rede stehenden Schaltgeräten im leitenden Zustand praktisch kein Spannungsabfall auftreten und im gesperrten Zustand praktisch kein Reststrom fließen. Da aber dann, wenn bei Schaltgeräten der in Rede stehenden Art im leitenden Zustand kein Spannungsabfall aufträte, auch keine Speisespannung für den Anwesenheitsindikator und ggf. den Schaltverstärker gewonnen werden könnte, und dann, wenn im gesperrten Zustand kein Reststrom flösse, auch kein Speisestrom gewonnen werden könnte, gilt für alle elektronischen Schaltgeräte mit nur zwei Außenleitern, daß im leitenden Zustand ein Spannungsabfall auftritt und im gesperrten Zustand ein Reststrom fließt.

Aus dem, was zuvor ausgeführt worden ist, folgt, daß dann, wenn schon, ungewollt, aber funktionsnotwendig bei elektronischen Schaltgeräten der hier in Rede stehenden Art im leitenden Zustand ein Spannungsabfall auftritt und im gesperrten Zustand ein Reststrom fließt, der Spannungsabfall und der Reststrom so gering wie möglich sein sollen.

Das Problem "Reduzierung des Spannungsabfalls im leitenden Zustand des Schaltgerätes" ist zunächst bereits in einem Teil der schon genannten Druckschriften behandelt, nämlich in den deutschen Offenlegungsschriften bzw. Auslegeschriften bzw. Patentschriften 19 51 137, 21 27 956, 26 13 423 und 27 11 877.

Bei elektronischen Schaltgeräten der hier in Rede stehenden Art ist auch bereits erkannt worden, daß sich der Spannungsabfall im leitenden Zustand des Schaltgerätes weiter reduzieren läßt, wenn man die Speiseschaltung zur Darstellung einer Speisespannung bzw. eines Speisestroms für den Anwesenheitsindikator und ggf. den Schaltverstärker mit einem DC-DC-Wandler versieht, - weil mit einem solchen DC-DC-Wandler im Senkundärkreis eine höhere Wandlerspannung als im Primärkreis gewonnen werden kann, folglich der Spannungsabfall im leitenden Zustand des Schaltgerätes geringer sein kann, als die benötigte Speisespannung für den Anwesenheitsindikator und ggf. den Schaltverstärker (vgl. die DE-Osen 28 08 156, 29 22 309 und 33 20 975).

Elektronische Schaltgeräte der hier in Rede stehenden Art können Gleichspannungs-Schaltgeräte, Wechselspannungs-Schaltgeräte, aber auch Allstrom-Schaltgeräte sein, also Schaltgeräte, die sowohl für eine Gleichspannung führende Betriebsspannungsquelle als auch für eine Wechselspannung führende Betriebsspannungsquelle geeignet sind. Bei Gleichspannungs-Schaltgeräten ist üblicherweise ein Ausgangstransistor als vom Anwesenheitsindikator gesteuerter elektronischer Schalter vorgesehen. Demgegenüber ist bei Wechselspannungs-Schaltgeräten üblicherweise ein Ausgangsthyristor als vom Anwesenheitsindikator gesteuerter elektronischer Schalter vorgesehen. Da bei einem elektronischen Schaltgerät ein Ausgangsthyristor in Verbindung mit einer Gleichspannung führenden Betriebsspannungsquelle nur dann verwendet werden kann, wenn er GTO-Eigenschaften hat (GTO = Gate-Turn-Off), ist bei Allstrom-Schaltgeräten als vom Anwesenheitsindikator gesteuerter elektronischer Schalter in der Regel ein Ausgangstransistor vorgesehen.

Weist ein elektronisches Schaltgerät der hier in Rede stehenden Art als vom Anwesenheitsindikator gesteuerter elektronischer Schalter einen Ausgangstransistor auf, so muß es sich dabei um einen Leistungstransistor handeln. Solche Leistungstransistoren sind dann problematisch, wenn sie bei relativ hohen Betriebsspannungen eingesetzt werden sollen, - wobei die sich z. B. aus einer 220 V Wechselspannung führenden Betriebsspannungsquelle nach Gleichrichtung ergebende pulsierende Gleichspannung schon eine für einen Leistungstransistor ausgesprochen hohe Betriebsspannung ist.

Bei dem elektronischen Schaltgerät, von dem die Erfindung ausgeht und das weiter unten in Verbindung mit einem Schaltbild noch näher erläutert werden soll (vgl. die Literaturstelle "Siemens Components", Bd. 21, 1983, Heft 6, Seiten 250 - 252), liegt nun ein MOS-FET-Leistungstransistor mit der Zenerdiode und dem Ausgangstransistor in Reihe. Dabei übernimmt der MOS-FET-Leistungstransistor im gesperrten Zustand des Schaltgerätes die für den Ausgangstransistor zu hohe Betriebsspannung, was ein MOS-FET-Leistungstransistor halbleitertechnologisch bedingt ohne weiteres kann.

Im Stand der Technik, von dem die Erfindung ausgeht, ist der am Schaltgerät im leitenden Zustand auftretende Spannungsabfall relativ hoch, wie weiter unten in Verbindung mit einem Schaltbild noch erläutert wird, beträgt der Spannungsabfall ca. 10 V. Der Erfindung liegt folglich die Aufgabe zugrunde, das bekannte Schaltgerät, von dem die Erfindung ausgeht, so auszugestalten bzw. weiterzubilden, daß es im leitenden Zustand einen geringeren Spannungsabfall aufweist.

Das erfindungsgemäße elektronische Schaltgerät, bei dem die zuvor hergeleitete und dargelegte Aufgabe gelöst ist, ist dadurch gekennzeichnet, daß der MOS-FET-Leistungstransistor selbstleitend ist.

Im folgenden werden der Ausgangspunkt der Erfindung, die der Erfindung zugrundeliegende Problematik, die Lehre der Erfindung sowie Ausgestaltungen und Weiterbildungen der Lehre der Erfindung anhand von zeichnerisch dargestellten Ausführungsbeispielen näher erläutert; es zeigt

Fig. 1     ein Schaltbild, teilweise nur schematisch, des elektronischen Schaltgerätes von dem die Erfindung ausgeht,

Fig. 2     ein der Fig. 1 entsprechendes Schaltbild, wiederum teilweise nur schematisch, einer bevorzugten Ausführungsform eines erfindungsgemäßen Schaltgerätes und

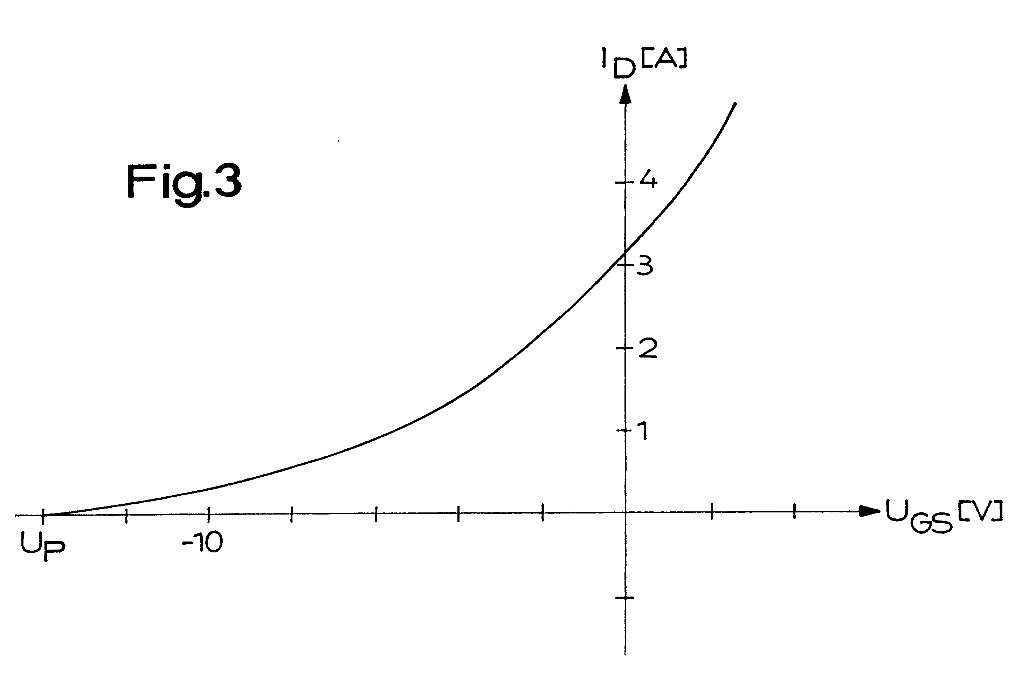

Fig. 3     eine grafische Darstellung der Kennlinie eines selbstleitenden MOS-FET-Leistungstransistors.

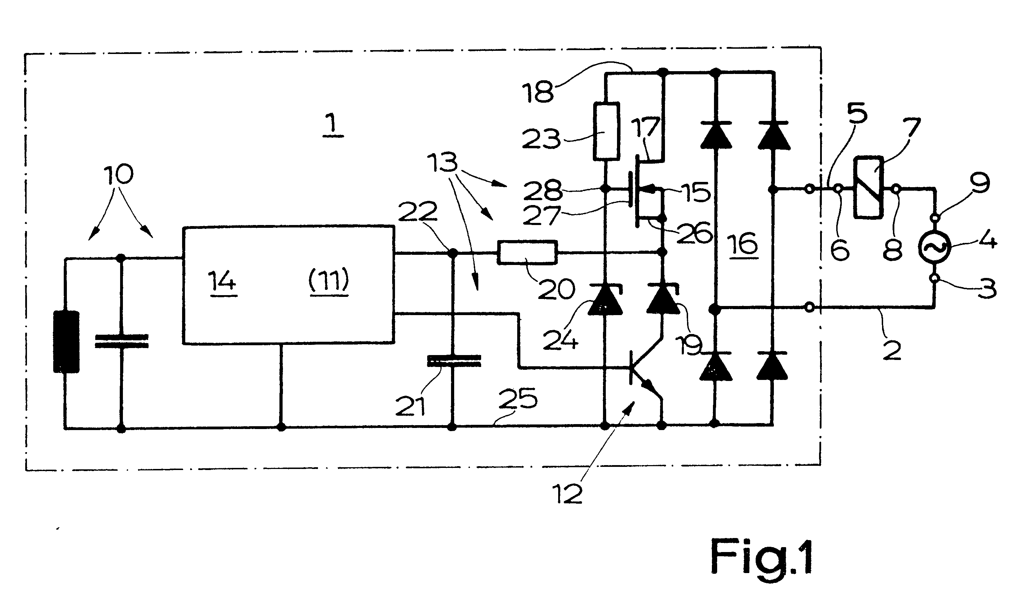

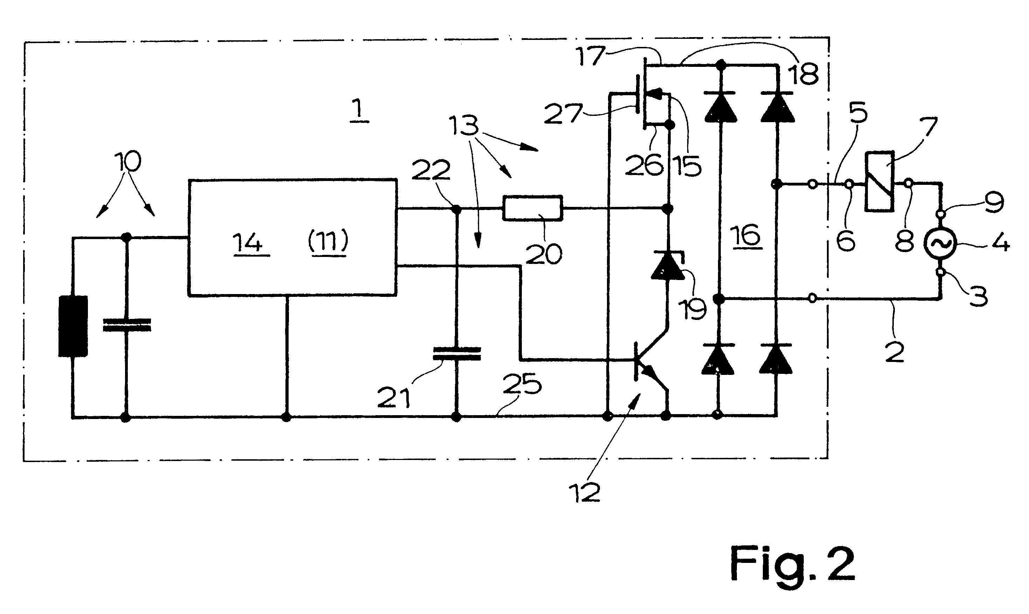

Die in den Fig. 1 und 2 dargestellten elektronischen Schaltgeräte 1 arbeiten berührungslos und sind jeweils über einen Außenleiter 2 mit einen Pol 3 einer - Gleichspannung oder Wechselspannung führenden, im dargestellten Ausführungsbeispiel Wechselspannung führenden - Betriebsspannungsquelle 4 und nur über einen weiteren Außenleiter 5 mit einem Anschluß 6 eines Verbrauchers 7 verbindbar, wobei der andere Anschluß 8 des Verbrauchers 7 mit dem anderen Pol 9 der Betriebsspannungsquelle 4 verbindbar ist. Es handelt sich also um ein Allstrom-Schaltgerät mit nur zwei Außenleitern, also um ein Zwei-Leiter-Allstrom-Schaltgerät.

In ihrem wesentlichen Aufbau bestehen die in den Fig. 1 und 2 dargestellten Schaltgeräte 1 aus einem von außen beeinflußbaren Anwesenheitsindikator 10, z. B., wie in den Fig. 1 und 2 angedeutet, einem Oszillator, aus einem von dem Anwesenheitsindikator 10 über einen Schaltverstärker 11 steuerbaren Ausgangstransistor 12 und aus einer Speiseschaltung 13 zur Bereitstellung einer Speisespannung bzw. eines Speisestroms für den Anwesenheitsindikator 10 und den Schaltverstärker 11.

Bei elektronischen Schaltgeräten der hier in Rede stehenden Art, so auch bei den in den Fig. 1 und 2 dargestellten Schaltgeräten 1, wird schon seit längerer Zeit ein integrierter Schaltkreis 14 verwendet, in dem ein Teil des Anwesenheitsindikators 10 und der Schaltverstärker 11 verwirklicht sind.

Bei den in den Fig. 1 und 2 dargestellten Schaltgeräten 1 weist die Speiseschaltung 13 zur Bereitstellung einer Speisespannung bzw. eines Speisestroms für den Anwesenheitsindikator 10 und den Schaltverstärker 11 einen MOS-FET-Leistungstransistor 15 auf, - wobei der MOS-FET-Leistungstransistor 15 als "Konstantspannungsgenerator" bzw. als "Konstantstromgenerator" wirkt. Weiter oben ist bereits ausgeführt worden, daß es belanglos ist, ob man die Speiseschaltung 13 als bestimmt zur Bereitstellung einer Speisespannung oder eines Speisestroms für den Anwesenheitsindikator 10 und den Schaltverstärker 11 ansieht. Folglich ist es auch belanglos, ob man den MOS-FET-Leistungstransistor 15 als "Konstantspannungsgenerator" oder als "Konstantstromgenerator" ansieht. Auch darf dabei "konstant" nicht mißverstanden werden. "Konstant" meint nicht über der Zeit konstant, meint also in Verbindung mit einer Wechselspannung führenden Betriebsspannungsquelle 4 nicht innerhalb jeder Periode konstant, und meint auch nicht konstant in einem engen Sinne. Der MOS-FET-Leistungstransistor 15 wirkt nur insoweit als "Konstantspannungsgenerator" bzw. als "Konstantstromgenerator", als er wesentlich dafür ist, daß dem Anwesenheitsindikator 10 und dem Schaltverstärker 11 die benötigte Speisespannung und der benötigte Speisestrom zur Verfügung gestellt wird,- unabhängig von der Höhe der Betriebsspannung, wenn diese einen Minimalwert nicht unterschreitet und einen Maximalwert nicht überschreitet. Der MOS-FET-Leistungstransistor 15 verhindert also, daß der durch das Schaltgerät 1 im gesperrten Zustand fließende Reststrom mehr oder weniger linear abhängig ist von der Höhe der Betriebsspannung. Nur diese Funktion wird hier unter "Konstantspannungsgenerator" bzw. unter "Konstantstromgenerator" verstanden.

Wie die Fig. 1 und 2 zeigen, liegen bei dem Schaltgerät 1, von dem die Erfindung ausgeht, und bei dem erfindungsgemäßen Schaltgerät 1 der MOS-FET-Leistungstransistor 15 und der Ausgangstransistor 12 in Reihe. Dadurch übernimmt der MOS-FET-Leistungstransistor 15 im gesperrten Zustand des Schaltgerätes 1 die für den Ausgangstransistor 12 zu hohe Betriebsspannung.

Im übrigen weisen die in den Fig. 1 und 2 dargestellten Schaltgeräte 1 eingangsseitig jeweils einen Brückengleichrichter 16 auf. Wird, wie in den Ausführungsbeispielen nach den Fig. 1 und 2, das Schaltgerät 1 an einer Wechselspannung führenden Betriebsspannungsquelle 4 betrieben, so liegt folglich an der Reihenschaltung aus dem MOS-FET-Leistungstransistor 15 und dem Ausgangstransistor 12 eine pulsierende Gleichspannung an.

Wie die Fig. 1 und 2 zeigen, gilt für die dargestellten Ausführungsbeispiele des Schaltgerätes 1, und zwar sowohl für das in Fig. 1 dargestellte bekannte Schaltgerät 1 als auch für das in Fig. 2 dargestellte erfindungsgemäße Schaltgerät 1, daß der Drain-Anschluß 17 des MOS-FET-Leistungstransistors 15 an den Pluspol 18 der zu schaltenden pulsierenden Gleichspannung angeschlossen ist, daß zwischen dem MOS-FET-Leistungstransistor 15 und dem Ausgangstransistor 12 eine Zenerdiode 19 geschaltet ist und daß parallel zu der Reihenschaltung aus der Zenerdiode 19 und dem Ausgangstransistor 12 die Reihenschaltung aus einem Ladewiderstand 20 und einem Ladekondensator 21 liegt. Am Verbindungspunkt von MOS-FET-Leistungstransistor 15 und Zenerdiode 19 bzw. am Verbindungspunkt 22 von Ladewiderstand 20 und Ladekondensator 21 wird für den Anwesenheitsindikator 10 und den Schaltverstärker 11 die Speisespannung und der Speisestrom zur Verfügung gestellt.

Bei dem im Stand der Technik bekannten, in Fig. 1 dargestellten Schaltgerät 1 sind noch, in Reihe zueinander liegend, ein Strombegrenzungswiderstand 23 und eine weitere Zenerdiode 24 vorgesehen. Die Reihenschaltung aus dem Strombegrenzungswiderstand 23 und der weiteren Zenerdiode 24 liegt einerseits am Pluspol 18 der zu schaltenden pulsierenden Gleichspannung, andererseits am Minuspol 25 der zu schaltenden pulsierenden Gleichspannung. An den Source-Anschluß 26 des MOS-FET-Leistungstransistors 15 sind einerseits die erste Zenerdiode 19, andererseits der Ladewiderstand 20 angeschlossen. Der Gate-Anschluß 27 des MOS-FET-Leistungstransistors 15 ist an die Verbindung 28 von Strombegrenzungswiderstand 23 und weiterer Zenerdiode 24 angeschlossen. Beim in Fig. 2 dargestellten Schaltgerät 1 ist der Gate-Anschluß 27 des MOS-FET-Leistungstransistors 15 an den Minuspol 25 der zu schaltenden pulsierenden Gleichspannung angeschlossen.

Bei dem bekannten, in Fig. 1 dargestellten Schaltgerät 1 ist der Spannungsabfall im leitenden Zustand noch relativ hoch. Er beträgt ca. 10 V und resultiert aus dem Spannungsabfall am Brückengleichrichter 16, aus der notwendigen Gate-Source-Spannung des MOS-FET-Leistungstransistors 15, dem Spannungsabfall an der Zenerdiode 19 und dem Spannungsabfall an der Kollektor-Emitter-Strecke des Ausgangstransistors 12.

Im Gegensatz zu dem bekannten, in Fig. 1 dargestellten Schaltgerät 1 weist das erfindungsgemäße, in Fig .2 dargestellte Schaltgerät einen geringeren Spannungsabfall. auf. Er beträgt ca. 6 V und resultiert aus dem Spannungsabfall am Brückengleichrichter 16, dem Spannungsabfall an der Drain-Source-Strecke des MOS-FET-Leistungstransistors 15, dem Spannungsabfall an der Zenerdiode 19 und dem Spannungsabfall an der Kollektro-Emitter-Strecke des Ausgangstransistors 12.

Während also bei dem bekannten, in Fig. 1 dargestellten Schaltgerät 1 im leitenden Zustand der Spannungsabfall wesentlich durch die notwendige Gate-Source-Spannung des MOS-FET-Leistungstransistors 15 - im ungünstigsten Fall 6 V - mitbestimmt wird, geht bei dem erfindungsgemäßen, in Fig. 2 dargestellten Schaltgerät 1 im leitenden Zustand der nur relativ geringe Spannungsabfall an der Drain-Source-Strecke des MOS-FET-Leistungstransistors 15 ein.

Im übrigen weist das in Fig. 2 dargestellte Schaltgerät 1 gegenüber dem bekannten, in Fig .1 dargestellten Schaltgerät 1 noch den Vorteil auf, daß die beim bekannten Schaltgerät 1 nach Fig. 1 notwendigen Bauteile Strombegrenzungswiderstand 23 und weitere Zenerdiode 24 nicht benötigt werden.

**Ansprüche**

1. Elektronisches, vorzugsweise berührungslos arbeitendes Schaltgerät, das über einen Außenleiter (2) mit einem Pol (3) einer - Gleichspannung oder Wechselspannung führenden - Betriebsspannungsquelle (4) und nur über einen weiteren Außenleiter (5) mit einem Anschluß (6) eines Verbrauchers (7) verbindbar ist, wobei der andere Anschluß (8) des Verbrauchers (7) mit dem anderen Pol (9) der Betriebsspannungsquelle (4) verbindbar ist, mit einem von außen beeinflußbaren Anwesenheitsindikator (10), z. B. einem Oszillator, mit einem von dem Anwesenheitsindikator (10) - ggf. über einen Schaltverstärker (11) - steuerbaren elektronischen Ausgangsschalter aus einem Ausgangstransistor (12) und einem MOS-FET-Leistungstransistor (15) und mit einer Zenerdiode (19), wobei der MOS-FET-Leistungstransistor (15), die Zenerdiode (19) und der Ausgangstransistor (12) in Reihe im Lastkreis liegen und wobei die Speisespannung bzw. der Speisestrom für den Anwesenheitsindikator (10) und ggf. den Schaltverstärker (11) am Verbindungspunkt von MOS-FET-Leistungstransistor (15) und Zenerdiode (19) bereitgestellt wird, **dadurch gekennzeichnet**, daß der MOS-FET-Leistungstransistor (15) selbstleitend ist.

2. Elektronisches Schaltgerät nach Anspruch 1, dadurch gekennzeichnet, daß, wie an sich bekannt, der Drain-Anschluß (17) des MOS-FET-Leistungstransistor (15) an den Pluspol (18) der zu schaltenden, ggf. pulsierenden Gleichspannung angeschlossen ist.

3. Elektronisches Schaltgerät nach Anspruch 1 oder 2, dadurch gekennzeichnet, daß, wie an sich bekannt, parallel zu der Reihenschaltung aus der Zenerdiode (19) und dem Ausgangstransistor (12) die Reihenschaltung aus einem Ladewiderstand (20) und einem Ladekondensator (21) liegt.

4. Elektronisches Schaltgerät nach einem der Ansprüche 1 bis 3, dadurch gekennzeichnet, daß der Gate-Anschluß (27) des MOS-FET-Leistungstransistors (15) an den Minuspol (25) der zu schaltenden, ggf. pulsierenden Gleichspannung angeschlossen ist.

**Claims**

1. An electronic switching equipment, preferably working without contact, that can be connected by one external conductor (2) to one pole (3) of a source of supply voltage (4) - supplying direct current or alternating current - and can be connected by only one further external conductor (5) to a connection (6) of a load (7), the other connection (8) of the load (7) being connectable to the other pole (9) of the source of supply voltage (4), with a presence indicator (10), e.g. an oscillator, that can be externally influenced, with an electronic output switch that can be controlled from the presence indicator (10) - possibly via a switching amplifier (11) - consisting of an output transistor (12) and a MOS-FET power transistor (15) and with a Zener diode (19), the MOS-FET power transistor (15), the Zener diode (19) and the output transistor (12) being connected in series in the load circuit, and the operating voltage or the operating current for the presence indicator (10) and possibly the switching amplifier (11) being made available at the junction point of the MOS-FET power transistor (15) and the Zener diode (19), *characterized in that* the MOS-FET power transistor (15) is self-conducting.

2. An electronic switching equipment according to Claim 1, *characterized in that*, as is in itself known, the drain connection (17) of the MOS-FET power transistor (15) is connected to the positive pole (18) of the possibly pulsating DC voltage that is to be switched.

3. An electronic switching equipment according to Claim 1 or Claim 2, *characterized in that*, as is in itself known, the series connection of a charging resistor (20) and a charging capacitor (21) is connected in parallel to the series connection of the Zener diode (19) and the output transistor (12).

4. An electronic switching equipment according to one of Claims 1 to 3, *characterized in that* the gate connection (27) of the MOS-FET power transistor (15) is connected to the negative pole (25) of the possibly pulsating DC voltage that is to be switched.

**Revendications**

1. Appareil électronique de coupure, travaillant de préférence sans contact, qui peut être raccordé par l'intermédiaire d'un conducteur extérieur (2) à un pôle (3) d'une source de tension de service (4) -délivrant une tension continue ou une tension alternative- et, uniquement par l'intermédiaire d'un autre conducteur extérieur (5), une borne (6) d'un appareil d'utilisation (7), l'autre borne (7) de l'appareil d'utilisation (7) pouvant être reliée à l'autre pôle (9) de la source de tension de service (4), et comportant un indicateur de présence (6) pouvant être influencé de l'extérieur, par exemple un oscillateur, un interrupteur électronique de sortie commandable par l'indicateur de présence (6) -éventuellement par l'intermédiaire d'un amplificateur de commutation (11)- et constitué par un transistor de sortie (12) et un transistor MOS-FET de puissance (15), et une diode Zener (19), le transistor MOS-FET de puissance (15), la diode Zener (19) et le transistor de sortie (12) étant branchés en série dans le circuit de charge, tandis que la tension d'alimentation ou le courant d'alimentation pour l'indicateur de présence (10) et éventuellement l'amplificateur de commutation (11) est fourni au niveau du point de jonction entre le transistor MOS-FET de puissance (15) et la diode Zener (19), caractérisé par le fait que le transistor MOS-FET de puissance (15) est auto-conducteur.

2. Appareil électronique de coupure selon la revendication 1, caractérisé en ce que, comme cela est connu en soi, la borne de drain (17) du transistor MOS-FET de puissance (15) est raccordée au pôle positif (18) de la tension continue, éventuellement pulsatoire, qui doit être interrompue.

3. Appareil électronique de ooupure selon la revendication 1 ou 2, caractérisé par le fait que. comme cela est connu en soi, le circuit série formé d'une résistance de charge (20) et d'un condensateur de charge (21) est branché en parallèle avec le circuit série formé de la diode Zener (19) et du transistor de sortie (12).

4. Appareil électronique de coupure suivant l'une des revendications 1 à 3, caractérisé par le fait que la borne de grille (27) du transistor MOS-FET de puissance (15) est raccordée au pôle négatif (25) de la tension continue, éventuellement pulsatoirement, devant être interrompue.

Fig.1

EP 0 169 468 B1

Fig. 2

Fig.3

EP 0 169 468 B1